# EUROPEAN PATENT SPECIFICATION

(11) **EP 0 383 519 B1**
(45) Date of publication and mention of the grant of the patent: **05.06.1996**
(21) Application number: 90301466.0
(22) Date of filing: 12.02.1990
(51) Int. Cl.: G11C 19/28, G11C 27/04, H01L 27/148, H04N 3/15

(54) **Charge coupled device imager having multichannel read-out structure**
Ladungsgekoppelte Abbildungsanordnung mit Mehrkanallesestruktur
Dispositif de prise de vue à CCD ayant une structure de lecture multicanal

(30) Priority: 14.02.1989 JP 34569/89
(43) Date of publication of application: 22.08.1990
(73) Proprietor: SONY CORPORATION, Tokyo (JP)
(72) Inventor: Iizuka, Tetsuya, Shinagawa-ku Tokyo (JP); Yonemoto, Kazuya, Shinagawa-ku Tokyo (JP); Wada, Kazushi, Shinagawa-ku Tokyo (JP); Nakamura, Satoshi, Shinagawa-ku Tokyo (JP); Harada, Koichi, Shinagawa-ku Tokyo (JP)
(74) Representative: Ayers, Martyn Lewis Stanley

(56) References cited:
- EP-A- 0 211 441
- US-A- 4 242 692
- US-A- 4 750 042
- IEEE JOURNAL OF SOLID-STATE CIRCUITS, vol. SC-13, no. 1, February 1978, pages 34-51; D. BARBE et al.: "Signal processing with charge-coupled devices"
- PATENT ABSTRACTS OF JAPAN, vol. 8, no. 95 (E-242)(1532), 02.05.84 & JP-A-59-13369

## Description

This invention relates to a CCD (charge coupled device) imager in which signal charges are transferred by a plurality of juxtaposed read-out registers.

In a CCD imager, such as an interline transfer (IT) or frame interline transfer (FIT) type CCD imager, there is known a structure, such as from the Japanese Patent laid open publication number 59-13369 (1984), in which, in order to reduce the read-out frequency of the horizontal register, signal readout is performed by a plurality of horizontal registers.

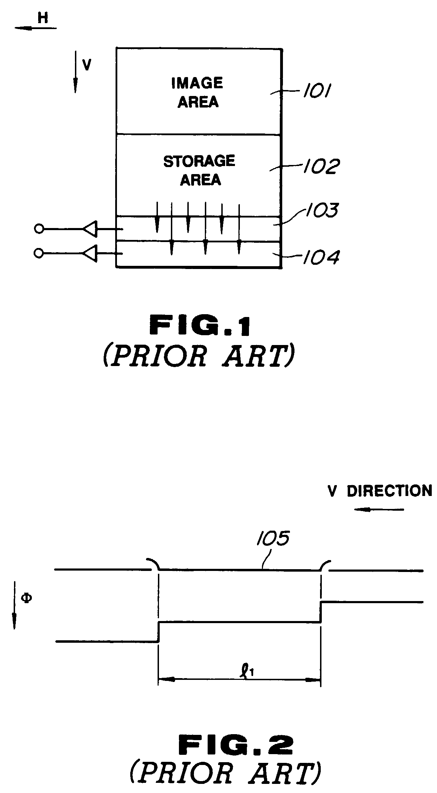

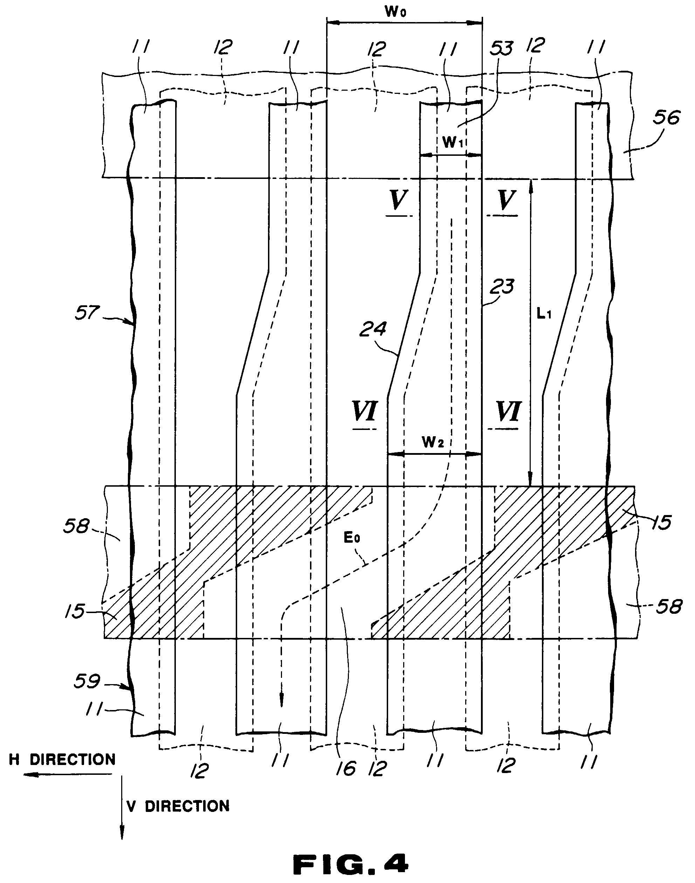

Figure 1 of the accompanying drawings shows an example of a dual read-out FIT type CCD imager in which signal read-out is performed by two horizontal registers. Signal charges are produced by photoelectric conversion in an image area 101 and transferred via a storage area 102 to a first horizontal register 103 and a second horizontal register 104. This storage area 102 is made up of a plurality of vertical registers and signal charges of every second vertical register are allocated to the first horizontal register 103 and the second horizontal register 104. It is noted that the signal charges to be transferred to the second horizontal register 104 at the distant side from the image area 101 are transferred by way of the first horizontal register 103.

However, the above described CCD imager is beset with the problem that the transfer efficiency between the horizontal registers can not be improved.

That is, the transfer electrodes of the horizontal registers 103, 104 are arranged, in view of the transfer along the horizontal direction, at a predetermined pitch along the horizontal direction. However, the vertical length of the transfer electrode of the horizontal register becomes longer than the horizontal length, such that, with an increase in the vertical length ℓ₁ of the electrode 105, as shown in figure 2, changes in the potential along the vertical direction are correspondingly reduced. The result is that flat potential portions are produced to lower the charge transfer efficiency from the first horizontal register 103 to the second horizontal register 104 in the vertical direction.

US 4,242,692 discloses a delay line having transfer electrodes which increase in width in the intended direction of flow of charge.

In order to solve this problem, fine potential steps can be formed, such as by ion implantation, along the vertical direction of the transfer electrode of the horizontal register. However, in such case, the manufacturing process is significantly complicated due to the necessity of forming photo resists and so forth.

It is an object of the present invention to provide a CCD imager in which the transfer efficiency between a plurality of juxtaposed read-out registers can be improved.

According to the present invention, there is provided a CCD imager comprising:
an image area having a plurality of photo-sensitive regions which generate signal charges;
first and second juxtaposed read-out registers for transferring and reading out signal charges from the image area in one direction, the first read-out register being closer to the image area than the second read-out register and being capable of transferring the signal charges thereto;
a plurality of pairs of spaced apart transfer electrodes extending from the image area through the read-out registers; and
channel stop regions provided under the transfer electrodes at the end of every second storage region of the first read-out register and each extending across the entire width of the first transfer electrodes of two adjacent pairs leaving a channel region to guide the signal charges to flow from under the first transfer electrode of one of said adjacent pairs in the first read-out register to under the first transfer electrode of the other of said adjacent pairs in the second read-out register through a transfer gate; characterised in that:
a first of each pair of transfer electrodes has a first side which is substantially linear and a second side which is bent or non-linear so that the width of the transfer electrode increases in the region of the first read-out register, the width of the transfer electrode being taken in the direction of charge transfer in the read-out registers, so that the electrode is wider at the end thereof near the second read-out register than at the end near the image area.

The CCD imager of the present invention includes a plurality of photo-sensitive regions arrayed in a matrix configuration, and horizontal registers as read-out registers which transfer signal charges from these photo-sensitive regions by way of vertical registers are each provided for one column of the matrix. The photo-sensitive regions, the horizontal registers and the vertical registers are formed on a semiconductor substrate. Storage regions and transfer regions are formed in each horizontal register sequentially, alternately in the horizontal transfer direction. These storage and transfer regions correspond in structure to the transfer electrodes. The transfer electrodes are formed on the semiconductor substrate through an insulating film, and clock pulses are separately applied to the transfer electrodes.

The invention will be further described by way of non-limitative example with reference to the accompanying drawings, in which:-

Figure 1 is a schematic view for illustrating a conventional dual read-out CCD.

Figure 2 is a schematic view for illustrating the problem inherent in the horizontal register of the conventional CCD depicted in figure 1.

Figure 3 is a block diagram for illustrating the overall structure of a CCD imager according to an embodiment of the present invention.

Figure 4 is a plan view showing essential parts of the CCD imager shown in figure 3.

Figure 5 is a diagram showing a potential curve along line V-V in figure 4.

Fig. 6 is a diagram showing a potential curve along line VI-VI in Fig. 4.

The CCD imager of the present invention is a FIT type CCD having two juxtaposed horizontal registers, in which the charge transfer efficiency is improved thanks to the shape of storage regions of the horizontal register.

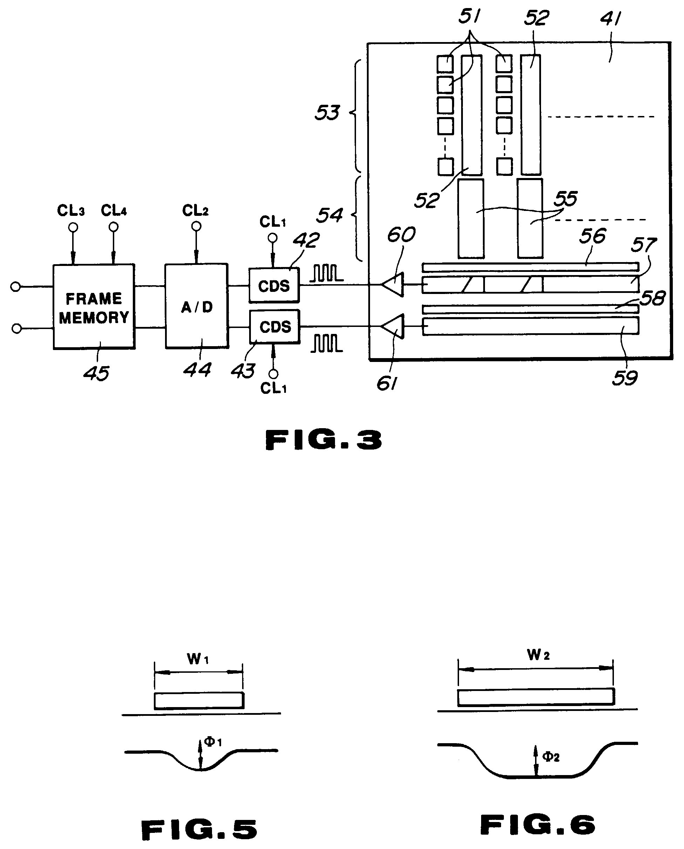

Before proceeding to the description of the horizontal register, the CCD imager will be explained briefly with reference to Fig. 3. Photo-sensitive regions 51 are arranged in a matrix configuration in a CCD imager 41 and a plurality of vertical registers 52 are provided one for each column in the vertical direction or in the up-and-down direction in Fig. 4 of the CCD imager 41. An image area 53 is made up of these photo-sensitive regions 51 and the first vertical registers 52. Contiguous to the ends of these first vertical registers 52 are second vertical registers 55 functioning as a storage area 54 of the FIT type CCD imager. On the ends opposite to the first vertical registers 52 of the second vertical register 55, there is provided a first horizontal register 57 with a transfer gate 56 in-between. This first horizontal register 57 transfers electrical charges in the horizontal direction, that is, in the left-and-right direction in Fig. 4, while functioning as the charge transfer channel or route to the other horizontal register 59. As will be explained subsequently, the width of the storage region within the horizontal register is changed in the vertical direction (as viewed in Fig. 4) so that it is narrower at the image area side than at the second horizontal register side to improve the efficiency of the vertical charge transfer in the first horizontal register 57. Beyond the first horizontal register 57 in the vertical direction, a second horizontal register 59 is provided in juxtaposition to the first horizontal register 57 with a transfer gate 58 in- between. This second horizontal register 59 transfers the charges in the horizontal direction, similarly to the first horizontal register 57, which charges have been transferred to the second horizontal register 59 by way of the storage region in the first horizontal register 57.

Referring to Fig. 4, the first and the second horizontal registers will be explained in more detail. The first horizontal register 57 and the second horizontal register 59, provided each with transfer electrodes, formed by second and third polysilicon layers, are arranged in juxtaposition to each other. Transfer gates 56 and 58 are formed by a first polysilicon layer. The transfer gate 56 is provided between the second vertical register and the first horizontal register 57 to a predetermined width in the horizontal direction in the drawing as the longitudinal direction. The transfer gates 56, 58 are arrayed with a distance L₁ therebetween and in juxtaposition to each other. Below the transfer gate 58, a channel stop region 15 shown by hatched lines is formed by selective introduction therein of impurities. The channel stop region 15 is provided at the end of every second storage region of the first horizontal register 57, and functions to render the first horizontal register electrically nonconductive with respect to the second horizontal register 59 thanks to the thus formed potential barrier. The region under the transfer gate 58 where the channel stop region 15 is not formed thus functions as a channel region 16, by means of which charges are transferred from the first horizontal register 57 to the second horizontal register 59.

The second polysilicon layer forms transfer electrodes 11, corresponding to the storage regions, in the first horizontal register 57 and the second horizontal register 59. The storage regions in a P type semiconductor substrate or well are formed by an N type impurity implantation using the transfer gates 56, 58 as a mask prior to forming these transfer electrodes 11. These transfer electrodes 11 are arranged in a plurality of patterns with a dimension W₀ as the pitch, and are extended from the upper part of the transfer gate 56 across the first horizontal register 57 as far as the transfer gate 58 and thence to the second horizontal register 59 for functioning as the transfer electrode of the second horizontal register 59. The transfer electrode 11 is formed with the vertical direction in the drawing as the longitudinal direction. Above all, the transfer electrode 11 in the first horizontal register 57 is so contoured that a confronting side 23 in the charge transfer direction or in the H direction is substantially linear and the other confronting side 24 is bent or nonlinear so that the width W₁ of the transfer electrode 11 at the side of the image area 53 is narrower than the width W₂ at the side of the second horizontal register 59. Since the contour of the transfer electrode 11 corresponds to that of the storage region, the width W₁ of the storage region at the side of the image area is lesser than the width W₂ thereof at the side of the second horizontal register 59. It is noted that the lower portion of the transfer electrode 11 similarly functions as the storage region in the second horizontal register 59.

Figs. 5 and 6 show the state of the potential at the storage region of the first register 57. Fig. 5 is taken along line V-V in Fig. 4 and shows the state of the potential at the side of the image area of the storage region. Fig. 6 is taken along line VI-VI of Fig. 4 and shows the state of the potential at the side of the second horizontal register 59 of the storage region. With a narrower width W₁ of the storage region, as shown in Fig. 5, the potential depth φ₁ becomes shallow under the effect of the potential of the neighboring region. With a broader width W₂ of the storage region, as shown in Fig. 6, the potential depth φ₂ becomes deep. Hence, in Fig. 4, the potential depth becomes deeper in proceeding from the side of the image area 53 towards the side of the second horizontal register 59 in spite of the fact that the storage regions have a uniform impurity concentration. The gradient of the potential enables signal charges to be transferred more easily to the second horizontal register 59.

In the first horizontal register 57 and the second horizontal register 59, the third polysilicon layer proves to be the transfer electrodes 12 corresponding to the transfer regions within the register. The transfer regions are formed in the semiconductor substrate by an impurity implantation using the transfer electrodes 11 as a mask. These transfer electrodes 12 are formed in the first horizontal register 57 adjacent to the transfer electrode 11 contoured so as to be enlarged towards the second horizontal register 59, with the sides of the transfer electrodes 12 overlapping with the transfer electrodes 11. Similarly to the transfer electrode 11, the transfer electrode 12 is extended from the upper region of the transfer gate 56 through the first horizontal register 57 as far as the transfer gate 58 and thence extended further to the second horizontal register 59 for functioning as the transfer electrode. Within the horizontal registers 57 and 59, the transfer electrode 12 functions as the transfer region.

In Fig. 4, interlayer insulating films and so forth are not shown for clarity.

With the above described CCD imager of the present invention, having the first horizontal register 57, electrical charges are transferred on a transfer route E₀ shown by an arrow in Fig. 4. Thus the charges on the first horizontal register 57, which are not impeded in transfer by the channel stop region 15, are transferred to the second horizontal register 59, under the control of the transfer gate 58. As shown in Figs. 5 and 6, the potential in the transfer route E₀ becomes deeper, as the side end of the second register 59 is approached, for performing an efficient charge transfer. Thus a horizontal charge transfer can be realized, in which the read-out frequency is lowered by virtue of the horizontal registers 57 and 59. In the CCD imager production process, there is no necessity of increasing the number of process steps since it only suffices to change the masks.

Turning again to Fig. 3, an embodiment in which the output from a CCD imager 41 is issued without phase synchronizing or coinciding, is explained.

It is known that with a conventional CCD imager having two horizontal registers the signal of one of the horizontal registers is phase-shifted by 180° with respect to the other. With the CCD imager 41 of the present embodiment, however, signals having the same phase are outputted. Thus the signals outputted from output buffers 60, 61 of the CCD 41 are not subjected to half-bit synchronizing or coinciding treatment and are thus of the same phase with respect to each other. The signals from the output buffers 60, 61 are processed by correlated double sampling circuits (CDS) 42, 43 before being converted from the analog state into the digital state by an A/D converter 44. When the signals are outputted in this manner without coincidizing treatment, a clock CL₁ can be used in common in the correlated double sampling circuits 42, 43. The same can apply for the clock CL₂ supplied to the A/D converter 44. This helps eliminate the problem of pulse signal coupling and relieves the load which would be caused by generation of a number of clock types. A frame memory 45 is provided to receive the output of the A/D converter 44. The coinciding can be performed using clocks CL₃ and CL₄ supplied to the frame memory 45. In this manner, low-speed signals suffice at the downstream side of the frame memory 45 to simplify the pulses while reducing costs.

The present invention is not only applicable to a CCD imager in which the signals are outputted without a coinciding operation, but can also be applied to a CCD imager in which half-bit coinciding is performed in one of the horizontal registers. The CCD imager of the present invention is not limited to the FIT type structure, but can also be of an IT type structure. Although the foregoing description has been made of a CCD imager making use of two horizontal registers, the present invention can also be applied to a CCD imager making use of three or more horizontal registers in which the storage region of one of the horizontal registers transferring signal charges to the other registers is so contoured in plan as to have a narrow width on the side of the image area and a broad width on the side of the other registers.

## Claims

1. A CCD imager comprising:
an image area (53) having a plurality of photo-sensitive regions (51) which generate signal charges;
first and second juxtaposed read-out registers (57, 59) for transferring and reading out signal charges from the image area in one direction, the first read-out register being closer to the image area than the second read-out register and being capable of transferring the signal charges thereto;
a plurality of pairs of spaced apart transfer electrodes (11, 12) extending from the image area through the read-out registers; and
channel stop regions (15) provided under the transfer electrodes at the end of every second storage region of the first read-out register and each extending across the entire width of the first transfer electrodes of two adjacent pairs leaving a channel region (16) to guide the signal charges to flow from under the first transfer electrode of one of said adjacent pairs in the first read-out register (57) to under the first transfer electrode of the other of said adjacent pairs in the second read-out register (59) through a transfer gate (58); characterised in that:
a first of each pair of transfer electrodes has a first side (23) which is substantially linear and a second side (24) which is bent or non-linear so that the width of the transfer electrode increases in the region of the first read-out register, the width of the transfer electrode being taken in the direction of charge transfer in the read-out registers, so that the electrode is wider at the end thereof near the second read-out register than at the end near the image area.

2. The CCD image according to claim 1 wherein the image area (53) includes photo-sensitive regions (51) in a matrix configuration and first vertical registers (52) for transferring the signal charges from the photo-sensitive regions, and wherein the juxtaposed read-out registers include horizontal registers.

3. The CCD imager according to claim 2 wherein second vertical registers (55) for transiently storing electrical charges are provided between each vertical register in the image area and the horizontal registers (57, 59).

4. The CCD imager according to any one of the preceding claims wherein the other of each pair of transfer electrodes is provided between the one transfer electrodes and corresponding to transfer regions, each of the other transfer electrodes having a pattern such that the end near the image area is broader in width than the end near the second horizontal register.

5. The CCD imager according to claim 4 wherein a transfer gate comprised of a first electrode layer is provided between the read-out registers and the first and second transfer electrodes are formed in common from second and third electrode layers.

6. A CCD imager according to any one of the preceding claims further comprising
a semiconductor substrate of one conductivity type, said plurality of photo-sensitive regions (51) being formed therein in a row and column matrix configuration;
a plurality of vertical registers (52, 55) formed in the semiconductor substrate, one vertical register being provided for each column of the photo-sensitive regions;
a plurality of storage regions of the other conductivity type formed in the first read-out registers, the storage regions in the first read-out register being capable of transferring the signal charges to the second read-out register and having a width that increases in the region of the first read-out register so as to be wider at the end thereof nearer the second read-out register than the end nearer the image area;
a plurality of transfer regions of the other conductivity type which have an electrical potential depth which is shallower than the storage regions, the transfer regions being provided between the storage regions in the horizontal registers; and
at least one transfer gate (56) provided between the horizontal registers; wherein
the plurality of transfer electrodes are formed on the semiconductor substrate via an insulating film, the transfer electrodes being formed on the storage regions and the transfer regions, the transfer electrodes being for the purpose of applying clock pulses for transferring the signal charges.

## Patentansprüche

1. CCD-Abbildungseinrichtung, mit:
einem Bildbereich (53), der mehrere fotoempfindliche Bereiche (51) besitzt, die Signalladungen erzeugen;
erste und zweite nebeneinanderliegende Lesespeicher (57, 59) zum Transferieren und Lesen der Signalladungen vom Bildbereich in einer Richtung, wobei der erste Lesespeicher näher am Bildbereich ist als der zweite Lesespeicher und in der Lage ist, die Signalladungen dahin zu transferieren;
mehrere Paare von voneinander beabstandeten Transferelektroden (11, 12), die sich vom Bildbereich über die Lesespeicher erstrecken; und
Kanalstoppbereiche (15), die unter den Transferelektroden am Ende eines jeden zweiten Speicherbereichs des ersten Lesespeichers vorgesehen sind und sich jeweils quer zur gesamten Breite der ersten Transferelektroden von zwei benachbarten Paaren ausdehnen, die einen Kanalbereich (16) freilassen, um die Signalladungen so zu führen, damit sie von unterhalb der ersten Transferelektrode einer der benachbarten Paare im ersten Lesespeicher (57) zum unterhalb der ersten Transferelektrode des anderen der benachbarten Paare im zweiten Lesespeicher (59) über ein Transfertor (58) fließen,
dadurch gekennzeichnet, daß
ein erstes eines jeden Paars von Transferelektroden eine erste Seite (23) besitzt, die in etwa geradlinig ist, und eine zweite Seite (24), die gebogen oder nichtgeradlinig ist, so daß die Breite der Transferelektrode im Bereich des ersten Lesespeichers ansteigt, wobei die Breite der Transferelektrode in der Richtung der Ladungsübertragung in den Lesespeicher herangezogen wird, so daß die Elektrode am Ende in der Nähe des zweiten Speichers breiter ist als am Ende in der Nähe des Bildbereichs.

2. CCD-Abbildungseinrichtung nach Anspruch 1, wobei der Bildbereich (53) fotoempfindliche Bereiche (51) in einer Matrixkonfiguration und erste vertikale Speicher (52) zum Transfer der Signalladungen von den fotoempfindlichen Bereichen umfaßt, und wobei die nebeneinanderliegenden Lesespeicher horizontale Speicher aufweisen.

3. CCD-Abbildungseinrichtung nach Anspruch 2, wobei zweite vertikale Speicher (55) zur vorübergehenden Speicherung elektrischer Ladungen zwischen jedem vertikalen Speicher im Bildbereich und den horizontalen Speichern (57, 59) vorgesehen sind.

4. CCD-Abbildungseinrichtung nach einem der vorhergehenden Ansprüche, wobei das andere eines jeden Paars von Transferelektroden zwischen den einen Transferelektroden vorgesehen ist und entsprechend den Transferbereichen jede der anderen Transferelektroden ein solches Muster besitzt, daß das Ende in der Nähe des Bildbereichs bezüglich der Breite breiter ist als das Ende in der Nähe des zweiten horizontalen Speichers.

5. CCD-Abbildungseinrichtung nach Anspruch 4, wobei ein Transfertor, das aus einer ersten Elektrodenschicht besteht, zwischen den Lesespeichern vorgesehen ist, und die ersten und zweiten Transferelektroden gemeinsam von den zweiten und dritten Elektrodenschichten gebildet sind.

6. CCD-Abbildungseinrichtung nach einem der vorhergehenden Ansprüche, die außerdem aufweist;
ein Halbleitersubstrat eines Leitförmigkeitstypus, auf dem die mehreren fotoempfindlichen Bereiche (51) in einer Reihen-und Spalten-Matrixkonfiguration gebildet sind;
mehrere vertikale Speicher (52, 55), die auf dem Halbleitersubstrat gebildet sind, wobei ein vertikaler Speicher für jede Spalte der fotoempfindlichen Bereiche vorgesehen ist;
mehrere Speicherbereiche des anderen Leitförmigkeitstypus, die in den ersten Lesespeichern gebildet sind, wobei die Speicherbereiche im ersten Lesespeicher in der Lage sind, die Signalladungen zum zweiten Lesespeicher zu transferieren und eine Breite besitzen, die im Bereich des ersten Lesespeichers so ansteigt, daß sie an dessem Ende in der Nähe des zweiten Lesespeichers breiter ist als am Ende in der Nähe des Bildbereichs;
mehrere Transferbereiche des anderen Leitförmigkeitstypus, die eine elektrische Potentialtiefe besitzen, die flacher ist als die Speicherbereiche, wobei die Transferbereiche zwischen den Speicherbereichen in den horizontalen Speichern vorgesehen sind; und
zumindest ein Transfertor (58), das zwischen den horizontalen Speichern vorgesehen ist; wobei
die mehreren Transferelektroden auf dem Halbleitersubstrat über einem Isolationsfilm gebildet sind, wobei die Transferelektroden auf den Speicherbereichen und den Transferbereichen gebildet sind, wobei die Transferelektroden dazu dienen, Taktimpulse zum Transferieren der Signalladungen anzulegen.

## Revendications

1. Dispositif de formation d'image CCD comportant:
une zone image (53) possédant une pluralité de zones photoélectriques (51) qui génèrent des charges de signal;
des premier et second registres de lecture juxtaposés (57, 59) pour transférer et lire des charges de signal provenant de la zone image dans une direction, le premier registre de lecture se trouvant plus près de la zone image que le second registre de lecture et étant apte à transférer les charges de signal à celui-ci;
une pluralité de paires d'électrodes de transfert espacées (11, 12) s'étendant depuis la zone image à travers les registres de lecture; et
des régions d'arrêt de canal (15) prévues au-dessous des électrodes de transfert à l'extrémité de chaque zone de stockage sur deux du premier registre de lecture et s'étendant chacune sur toute la largeur des première électrode de transfert de deux paires adjacentes quittant une région de canal (16) pour guider l'écoulement des charges de signal depuis le dessous de la première électrode de transfert d'une desdites paires adjacentes dans le premier registre de lecture (57) vers le dessous de la première électrode de transfert de l'autre desdites paires adjacentes dans le second registre de lecture (59) par l'intermédiaire d'une grille de transfert (58); caractérisé en ce que :
une première de chaque paire d'électrodes de transfert possède un premier côté (23) qui est sensiblement linéaire et un second côté (24) qui est courbé ou non linéaire de sorte que la largeur de l'électrode de transfert augmente dans la région du premier registre de lecture, la largeur de l'électrode de transfert étant prise dans la direction de transfert de charge dans les registres de lecture, de sorte que l'électrode est plus large à son extrémité près du second registre de lecture qu'à une extrémité proche de la zone image.

2. Dispositif de formation d'image CCD selon la revendication 1, dans lequel la zone image (53) comprend des zones photoélectriques (51) selon une configuration matricielle et des premiers registres verticaux (52) pour transférer les charges de signal depuis les zones photoélectriques, et dans lesquels les registres de lecture juxtaposés comprennent des registres horizontaux.

3. Dispositif de formation d'image CCD selon la revendication 2, dans lequel des seconds verticaux (55) afin de mémoriser temporairement des charges électriques sont prévus entre chaque registre vertical dans la zone image et les registres horizontaux (57, 59).

4. Dispositif de formation d'image CCD selon l'une quelconque des revendications précédentes, dans lequel l'autre de chaque paire d'électrodes de transfert est prévue entre les premières électrodes de transfert et correspondant à des zones de transfert, chacune des autres électrodes de transfert présentant une configuration de telle sorte que l'extrémité près de la zone image soit plus large que l'extrémité proche du second registre horizontal.

5. Dispositif de formation d'image CCD selon la revendication 4, dans lequel une grille de transfert constituée d'une première couche d'électrode est prévue entre les registres de lecture et les première et seconde électrodes de transfert sont formées en commun à partir de seconde et troisième couches d'électrode.

6. Dispositif de formation d'image CCD selon l'une quelconque des revendications précédentes, comportant en outre :
un substrat semiconducteur d'un type de conductivité, ladite pluralité de zones photoélectriques (51) étant réalisée dans celui-ci selon une configuration matricielle à lignes et colonnes;
une pluralité de registres verticaux (52, 55) formés dans le substrat semiconducteur, un registre vertical étant prévu pour chaque colonne des zones photoélectriques;
une pluralité de zones de stockage de l'autre type de conductivité formées dans les premiers registres de lecture, les zones de stockage dans le premier registre de lecture étant aptes à transférer les charges de signal vers le second registre de lecture et possédant une largeur croissante dans la région du premier registre de lecture de manière à être plus large à son extrémité plus proche du second registre de lecture que l'extrémité plus proche de la zone image;
une pluralité de régions de transfert de l'autre type de conductivité qui possèdent une profondeur de potentiel électrique qui est plus mince que les zones de stockage, les régions de transfert étant prévues entre les zones de stockage dans les registres horizontaux; et
au moins une grille de transfert (56) prévue entre les registres horizontaux; dans lequel
la pluralité d'électrodes de transfert sont formées sur le substrat semiconducteur par l'intermédiaire d'une pellicule isolante, les électrodes de transfert étant formées sur les zones de stockage et les régions de transfert, les électrodes de transfert ayant pour but d'appliquer des impulsions d'horloge pour transférer les charges de signal.
